Europäisches Patentamt

European Patent Office

Office européen des brevets

(11) Publication number: **0 042 136**
**A1**

# EUROPEAN PATENT APPLICATION

(21) Application number: **81104460.1**

(22) Date of filing: **10.06.81**

(51) Int. Cl.³: **G 03 G 15/00, G 03 B 27/58**

(30) Priority: **12.06.80 AU 4023/80**

(43) Date of publication of application: **23.12.81**
**Bulletin 81/51**

(84) Designated Contracting States: **AT BE CH DE FR GB LI LU NL SE**

(71) Applicant: **Coulter Systems Corporation, 35 Wiggins Avenue, Bedford Massachusetts 01730 (US)**

(72) Inventor: **Matkan, Josef, 56 Sheffield Street, Malvern, South Australia 5061 (AU)**

(74) Representative: **Dorner, Jörg, Dr.-Ing. et al, Dorner + Hufnagel Patentanwälte Landwehrstrasse 37, D-8000 München 2 (DE)**

(54) **Registration method and means.**

(57) Retractable pin register means for use in sheet member processing equipment comprising a reversible platen (1) to support resilient membrane members (8) comprising at least one recess in the platen having in it a resilient member (8) carrying a pin bar (6) having pins (5) projecting beyond the planar surface of the platen by flexing the side membrane and means (14) for actuating the pin bar (6) on the remote side of the member from the pins whereby to register apertured sheet members on the platen but retractable to allow a free surface for subsequent treatment while holding the sheet members by vacuum or other means.

ACTORUM AG

2.

## BACKGROUND OF THE INVENTION

In the well known art of electrophotography the photoconductive surface of a recording member is electrostatically charged, exposed to a light pattern and toned with dry or liquid dispersed electroscopic marking particles or so-called toner. The recording member may comprise a sheet of paper coated on one side with photoconductive zinc oxide composition as commonly used in office copiers, or it may comprise a plate of metal such as steel or aluminium containing on one side thereof a photoconductive layer, or it may comprise a flexible material such as a polyester film containing on one side thereof a thin conductive layer followed by a photoconductive layer.

Recording members comprising a metal or film base have been found to be useful in graphic arts, particularly in the fields of lithographic plate making, colour proofing and the like applications, and in many such instances it is necessary to expose the charged photoconductive surface to light by the so-called contact exposure method through a film positive or transparency which may comprise a so-called colour separation as is well known in the art, where such film positive must be in register with the recording member during exposure.

One processing equipment for such recording members operates as follows. There is provided a metallic platen which is horizontally mounted on pivots in such manner that it can be rotated 180° that is it can be fully inverted. In the normal position the first surface of the platen is uppermost whereas its second surface is lowermost. The first surface is provided with vacuum or magentic means to firmly hold a recording member thereto. The first surface is also provided with register means such as register pins. The recording member is placed in register over said register means on the first surface of the platen in its normal position and held thereto by said holding means. The recording member is charged electrostatically, following which a film positive is placed over and in register with the recording member. A transparent flexible sheet for instance of polyester contained within a frame is then lowered over the first surface of the platen and vacuum is applied between the flexible sheet and said surface to form intimate contact between the recording member and the film positive, following which the thus formed sandwich is exposed to light. After exposure the vacuum is released, the frame with the flexible sheet is raised, the film positive is removed and the platen is inverted 180$^{\circ}$ whereby its first surface with the recording member being held thereto now becomes the lowermost surface. Liquid toner is then applied to the surface of the recording member over a narrow gap formed between so-called developing electrodes and the recording member surface. After toning the platen is inverted again 180$^{\circ}$ to its normal position for further processing steps or removal of the recording member from the platen.

In a modified version of the above described processing equipment, both surfaces of the platen are provided with plate holding and registering means whereby two recording members can be processed simultaneously, that is one recording member on the upper platen surface can be electrostatically charged and exposed while a second recording member on the

4.

lower platen surface is toned.

It will be seen that in such processing equipment during exposure the upper platen surface is under vacuum whereas the lower platen surface is at atmospheric pressure and that the register pins must protrude from the upper platen surface for the registration of the recording member and of the film positive thereon and that after removal of the film positive following exposure and prior to inverting the platen 180$^{\circ}$ for toning such register pins must be retracted in order to prevent their interference with the developing electrodes. Thus there is need for a register pin retracting mechanism which is located within the platen that is between its upper and lower surface and furthermore there is need for such mechanism to permit application of vacuum to one platen surface while the other platen surface is at atmospheric pressure.

It is the object of this invention to provide an airtight register pin retracting mechanism for processing equipment of the kind described in the foregoing.

The object is achieved by a device comprising a platen having at least a working surface thereon with a recess in the working planar surface at at least one end thereof, resilient membrane means being attached to the platen within the recess to extend across the recess, pin means being carried by the membrane means on the side of the membrane means closest to the working planar surface to form a pin bar, lifting means being positioned on the opposite surface of the resilient membrance means and arranged to stretch the resilient membrane means in a direction which causes the pins on the pin means to protrude above the working planar surface of the platen to engage apertures in a sheet member when placed in register on the planar surface.

BRIEF DESCRIPTION OF THE DRAWINGS

FIG. 1 is a sectional side elevation of a preferred embodiment showing the pin means engaging a pair of sheet members on the working surface to register the pair of members,

FIG. 2 is a similar view but with the pin means retracted and one of the sheet members removed,

FIG. 3 is a sectional side elevation of a modified form having two oppositely positioned pin means, and

FIG. 4 is a schematic view showing how the pin means can be actuated electrically.

PREFERRED EMBODIMENT

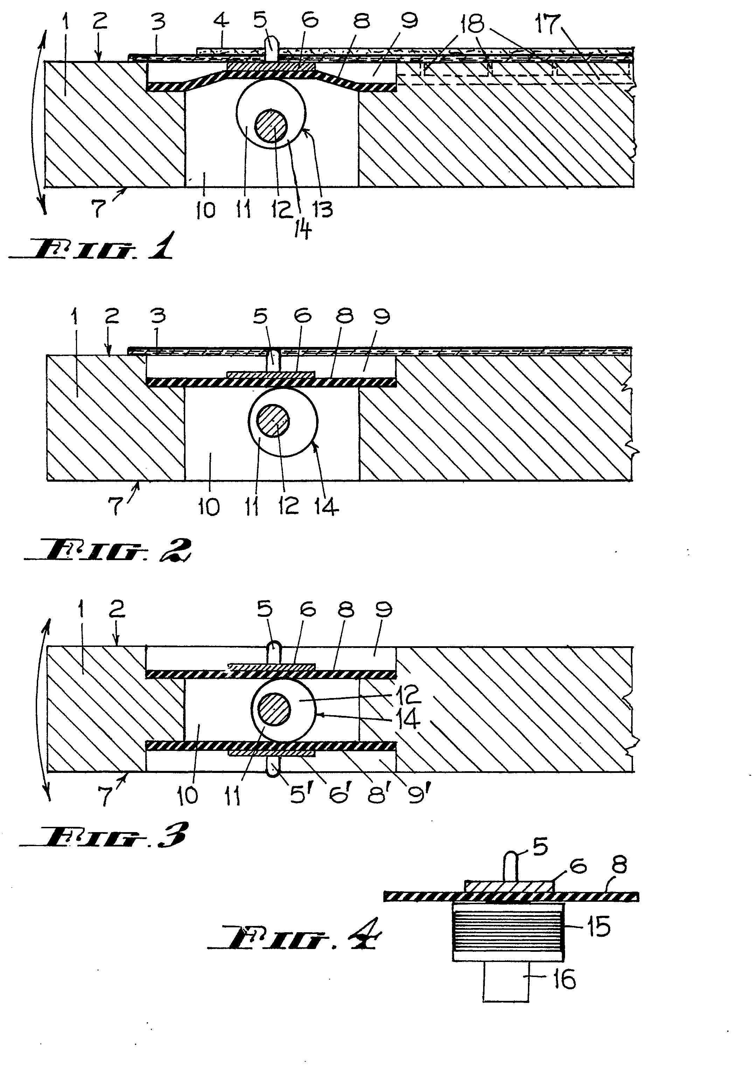

Referring first to FIG. 1, the platen 1 of the kind referred to in the foregoing has a first surface 2 which is adapted to hold by vacuum or magnetic means (not shown) a recording member 3 being placed in contact with a film positive 4 and in register therewith over the register pins 5 which are carried by the pin bar 6. To obtain intimate contact for exposure between the recording member 3 and film positive 4 which are placed in register as shown, the previously described frame with a transparent flexible sheet (not shown) is lowered over the sandwich and vacuum is applied between the flexible sheet and platen surface 2 while the second platen surface 7 remains at atmospheric pressure. The pin bar 6 is adhered or attached to a flexible membrane member 8

6.

which is wider and longer than the pin bar 6, as shown. In this case, the pin bar 6 is typically 1.0 inch wide while the flexible membrane 8 is about 1.0 inch wider all around and on each side than pin bar 6 to allow about 0.5 inch for flexing and stretching and about 0.5 inch for mounting. The register pins in a typical assembly are normally attached to the pin bar which is typically 1.0 inch wide, 18.25 inches long, 0.011 inch thick, carrying 5 equally spaced pins 0.085 inch high, but these dimensions are widely variable depending on for instance the dimensions of the platen and the sheet members being handled. The edges of the membrane 8 are mounted in airtight manner such as by means of adhesive preferably with additional cover strip and holding down screws (not shown) to the bottom of recess 9 which is milled to a suitable depth below surface 2 of platen 1. The slot 10 extending between end walls of the platen 1 contains the raising and lowering mechanism consisting of excentrics 11 fitted to a shaft 12 which is rotatably mounted in end walls (not shown) of platen 1 in such position that its vertical center line is preferably coincident with the center line of the row of pins 5 or of the pin bar 6. To raise the pins 5 the shaft 12 is rotated to its elevating position 13 as shown where the longer portion of excentric 11 contacts the lower side of the membrane 8 just beneath the centerline of the pins 5 or of the pin bar 6, and by stretching of membrane 8 raises the pins 5 for registration.

In FIG. 2 the pins 5 are shown in retracted position. The shaft 12 has been rotated by about 90° to a position where the shorter portion of the excentric 11 is virtually out of contact with the membrane 8 which due to its elasticity and flexibility assumes a position as shown, whereby the pins 5 are lowered. It will be noted that this configuration of FIG. 2 shows the condition after exposure, release of vacuum from the surface 2 of platen 1 and raising of the frame with flexible and transparent sheet therefrom and removal of film positive, preparatory to inverting the platen 1 by $180^{\circ}$ for toning from underneath.

The membrane 8 can be of rubber or elastomer and should be flexible and elastic for functionality in the present context. It should also be of solvent-resistant material as it may come into contact with the liquid toner during the step of toning.

The depth of the recess 9 should be equal at least to the thickness of the membrane 8 plus the thickness of pin bar 6 plus the length of the portion of pin 5 which is to be retracted, where such length depends on whether it is desired to retract the pin 5 to a position as shown in FIG. 2, that is to a position just beneath or level with the surface of recording member 3 or to position it beneath the surface 2 of the platen 1.

The difference between the longer and shorter radius of the excentric 11 can be selected in relation to the distance by which pin 5 is to be raised from the retracted position 14 to the elevated position 13.

The embodiment described in FIG. 1 is arranged to have pins projectable on opposite sides, the added membrane which is positioned in the recess 9' being designated 8', while the pin bar is designated 6' and the pins 5'.

8.

It will be realized that instead of an excentric disc 11 as shown in the drawings or a series of excentric discs suitably spaced on a common shaft 12, one or more cams on a common shaft can be used with equal advantage. Alternatively, membrane 8 can be raised and lowered by means other than cams or excentrics, such as for instance by one or more solenoids as shown in FIG.4, or by one or more hydraulically operated plungers and the like, where all such means can be located within the body of platen 1 between its surfaces 2 and 7. In FIG. 4 the solenoid is designated 15, and the solenoid plunger 16.

The shaft 12 is adapted to be rotated for raising or lowering the membrane 8 by manual or automatic or programmed means located outside of the platen 1. In like manner if solenoids or hydraulic plungers are used to raise and lower the membrane 8, these can also be adapted to be activated or controlled by manual or automatic or programmed means located outside of platen 1.

As stated earlier, the sheets can be held in close contact by vacuum or magnetic means and in FIG. 1 is shown in dotted lines a vacuum cavity 17 having apertures 18 communicating through the surface 2. The cavity can communicate with the space 9 as the space is sealed off at the back by the membrane 8.

Also, instead of the resilient membrane 8 having the pin bar 6 attached to it as shown, the pin bar could be embedded in the membrane or could be sealed to the other side with the pins sealingly projecting through the membrane.

9.

The arrows in FIG. 1 and 3 are to indicate that the platen can be rotated about a transverse or a longitudinal axis to reverse the portion of the surfaces 2 and 7.

10.

1.    Retractable pin register means for use in sheet member processing equipment; comprising

a platen having at least one working planar surface thereon,

a recess in said working planar surface at at least one end thereof,

resilient membrane means attached to said platen within said recess to extend across said recess,

pin means attached to said resilient membrane means comprising a bar having pins projecting on the side of the said membrane means closest to the said working planar surface of said platen to form a pin bar, and

lifting means adjacent the opposite surface of said resilient membrane means adapted to stretch said resilient membrane means in a direction which causes the pins on the said pin means to protrude above said working planar surface of said platen to engage apertures in a sheet member when placed in register on said planar surface.

2.    The registration means of Claim 1 arranged as an opposed pair to project one on one side of the said platen and the other on the other side thereof.

3.    For use in sheet member processing equipment of the type which includes platen means including at least one planar surface for supporting a sheet member in predetermined registration thereon, as defined in Claim 1 or 2.  The sheet member including aperture means formed therein at selected locations thereon, said pin means being capable of passing through said aperture means for effecting said registration characterised by said platen means including a hollow chamber formed therein opening to the planar surface thereof, pin support means seated within said hollow chamber, said pin support means movably arranged in proximity to said aperture means with said pin means and aligned therewith, flexible membrane means within said hollow chamber below said pin support, means for forcing said membrane means toward said planar surface and sealing off said surface for holding said sheet member on said surface by an applied force, said pin means being engageable within said aperture means for achieving registration, and means for selectively raising and lowering said pin means for releasably engaging same within said apertures in said sheet member.

4. The registration means according to Claim 3 wherein the applied force is a vacuum.

5. The registration means according to Claim 3 wherein the applied force is magnetic.

6. The registration means as claimed in Claim 3 in which said pin support means comprises a bar carrying at least a pair of pins secured thereon in a row transverse to the said platen and disposed normal to the surface of the said platen.

12.

7.    The registration means as claimed in Claim 3
wherein said membrane means are disposed within said
chamber below said pin means.


8.    The registration means as claimed in Claim 3
in which said raising and lowering means comprise cam
means engageable with said membrane means operable
thereon to raise and lower the membrane means within
said chamber to effect and to break said seal.


9.    The registration means as claimed in Claim 8
in which said cam means comprise at least an excentric
wheel mounted for rotation within said chamber below
said membrane means, rotation of said wheel member
causing said pin means to move outward of the planar
surface whereby to seat within said aperture means on
said sheet member.


10.    The registration means as claimed in Calim 8
wherein the said raising and lowering means comprise a
series of spaced excentric discs mounted for rotation
on a common shaft within said chamber and means for
rotating said shaft for raising and lowering said pin
support means forcing the pin means through said aperture means for effecting registration.


11.    The registration means as claimed in Claim 7
in which said pin support means is formed as a thin bar
having a planar surface, pins spaced in a transverse

0042136

13.

row secured to said planar surface, a recess formed in said sheet receiving surface and said bar seated therein with said pins aligned with said aperture means, said hollow chamber opening to said recess, said membrane means comprising a flexible membrane held to the said thin bar within said chamber and being larger than said recess.

12. The registration means as claimed in Claim 7 wherein the said flexible membrane is attached to the top surface of the thin bar.

13. The registration means as claimed in Claim 3 and solenoid means operating to raise and lower said pin means selectively to cause said pin means selectively to protrude exterior of said platen surface and to be retracted below said surface.

14. The registration means as claimed in Claim 3 in which a pair of sheet members are supportable upon said platen means and said pin means are selected of size and configuration to be capable of passing through said aperture means of said sheet members.

0042136

_FIG. 1_

_FIG. 2_

_FIG. 3_

_FIG. 4_

| DOCUMENTS CONSIDERED TO BE RELEVANT | | | CLASSIFICATION OF THE APPLICATION (Int. Cl.³) |
|---|---|---|---|
| Category | Citation of document with indication, where appropriate, of relevant passages | Relevant to claim | |
| | DE - B - 1 103 740 (KLIMSCH) <br>   * Fig. 1-3; column 4 * <br><br> -- | 1,3,4,6, 8,9,10, 13,14 | G 03 G 15/00 <br> G 03 B 27/58 |
| | US - A - 4 194 836 (RAPP) <br>   * Fig. 2; claims * <br><br> -- | 1,3,5, 13 | |
| | US - A - 4 080 068 (MADIGAN) <br>   * Fig. 1-4; claims * <br><br> -- | 1,3,4,7, 11,12 | |
| | US - A - 3 307 817 (COCITO) <br>   * Fig. 1-9; claims * <br><br> -- | 1,3,4 | **TECHNICAL FIELDS SEARCHED (Int. Cl.³)** |
| | US - A - 3 290 990 (GARLICK) <br>   * Fig. 1-8; column 2; claims * <br><br> -- | 1,3,6,8, 9,10 | G 03 B 27/00 <br> G 03 D 13/00 <br> G 03 D 15/00 <br> G 03 G 15/00 |
| | US - A - 3 204 544 (SHANNON) <br>   * Fig. 2,4,7; columns 3-5; claims * <br><br> ---- | 1,2,3,4, 5 | |

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

X | The present search report has been drawn up for all claims

| Place of search | Date of completion of the search | Examiner |
|---|---|---|
| VIENNA | 10-09-1981 | KRAL |

EPO Form 1503.1  06.78